Europäisches Patentamt

European Patent Office

Office européen des brevets

(11) Publication number: **0 014 327**
**A2**

# (12) EUROPEAN PATENT APPLICATION

(21) Application number: **80100133.0**

(51) Int. Cl.³: **G 01 R 33/12**

(22) Date of filing: **11.01.80**

(30) Priority: **06.02.79 US 9951**

(43) Date of publication of application:
**20.08.80 Bulletin 80/17**

(84) Designated Contracting States:
**DE FR GB NL**

(71) Applicant: **COMPACT VIDEO SYSTEMS, INC.**
**2813 West Alameda Avenue**
**Burbank, California 91505 (US)**

(72) Inventor: **Hansen, Stephan Charles**
**29406 Hillrise Drive**
**Agoura, California 91301 (US)**

(74) Representative: Patentanwälte Dipl.-Ing. A. Grünecker,
Dr.-Ing. H. Kinkeldey, Dr.-Ing. W. Stockmair,
Dr. rer. nat. K. Schumann, Dipl.-Ing. P.H. Jakob, Dr. rer.
nat. G. Bezold Maximilianstrasse 43
D-8000 München 22 (DE)

(54) Electronic video tape evaluator.

(57) Video recording tape is evaluated by first recording a color bar test pattern and then playing back the recorded information to provide an r-f signal from the tape. A drop-out detector (12) generates a change in output level during the time the r-f signal drops below a predetermined level. The output of the drop-out detector is applied to a weighting and averaging circuit (14) that averages a plurality of pulses from the drop-out detector over a time period that is long compared to the normal duration of signal drop-outs.

Fig. 3

-1-

# ELECTRONIC VIDEO TAPE EVALUATOR

## Field of the Invention

This invention relates to an electronic video tape evaluator, and more particularly, is concerned with a method and apparatus for evaluating and grading video tape stock.

## Background of the Invention

The use of magnetic tape to record and playback color video signals is well known. In many instances recording live directly on video tape has replaced using photographic film, since the video information recorded on magnetic tape can be converted directly into video signals for transmission. In some instances, large sums of money may be invested in the production of material which is recorded on magnetic tape. It is essential that the magnetic tape be of acceptable quality before it is used to record; otherwise the investment in the recording may be lost. Various types of gross flaws may be encountered in magnetic tape which can seriously impair or completely destroy the usefulness of the tape. These flaws must be detected before large sums are invested in producing a finished recording. Flaws in the tape take a variety of forms, some of which have negligible effect on the video signal reproduced from the recorded tape.

Manufacturers of magnetic tape screen the tape to determine if the tape meets industry standards for color video recording. One type of evaluation is to record a color bar test pattern on video tape and on playback detect the presence of dropouts, that is, any loss of RF signal during playback. Each dropout is counted and a dropout rate is established by averaging the number of dropouts over some period of time, such as over a previous one minute of playout time. A continuous "last one-minute average dropout count", for example, is recorded continuously to determine if the average dropout rate exceeds a predetermined level. Present manufacturing standards for 2" video tape specify that the dropout rate not exceed ten dropouts per minute on the average and not exceed twenty-five dropouts per minute in the highest one-minute average.

Such evaluator schemes, however, fail to flag certain types of gross flaws which render the magnetic tape unacceptable for high quality video recording. One problem is that a system which merely counts the number of dropouts to determine the average rate must mask dropouts shorter than some small arbitrary duration to avoid an intractably high dropout count. This duration has been specified to be $5\mu$seconds by SMPTE standard RP 47-1972. Unfortunately, by limiting the dropout detecting and counting to dropouts of duration longer than 5 microseconds, scratches in the tape, and similar types of defects may go undetected. However, tape scratches present a problem in recording and playback even though they are of such short duration. Scratches which run lengthwise of the tape cause dropouts in successive video signal tracks laid down by the scanning heads during the recording process. The dropouts caused by the scratches cannnot be covered up by the dropout compensator circuits in the video tape playback equipment. Further, because a single scratch occurs at the same point in successive tracks, the dropouts represent stationary

0014327

-3-

elements in the video picture and so produce a visual disturbance disproportionate to the amount of signal loss actually occurring.

Another problem with existing evaluator systems which count dropouts is that every dropout is counted the same regardless of the length of time the dropout is present. However, the time duration of a dropout is found to correspond closely to the size and severity of a physical defect in the tape oxide coating. A single large physical defect thus may not result in a high counting rate which would exceed the permissible counts per minute average. Because very short duration dropouts are masked out and longer duration dropouts are still only counted as a single dropout, present counting methods must use a relatively long averaging period. However, it has been found that many of the more serious tape defects, such as flaws in the backing, holes in the oxide, debris imbedded in oxide coating, and the like, often occur as an isolated single event in an otherwise clear area of the tape. Thus these types of flaws often go undetected where relatively long averaging times are required. Averaging times of a few seconds or shorter is essential for detecting these types of tape manufacturing faults.

Summary of the Invention

The invention is directed to an improved method and apparatus for detecting and analyzing flaws in color video recording tape such as is used in commercial quad head type video recording and playback equipment as well as slant-track type recording equipment used in less expensive video recording. The present invention utilizes a weighting and averaging circuit which responds to dropout impulses generated by a dropout detector circuit. The impulse weighting and averaging circuit responds to dropouts of impulses of extremely short duration. The circuit

-4-

of the present invention weighs the dropouts according to their duration as well as frequency. Furthermore, the weighting and averaging circuit of the present invention provides a relatively short averaging period of a few seconds which is impractical in an event counting type flaw detector system. The weighting and averaging circuit in effect responds to a number of short duration dropouts the same as it responds to a single dropout lasting the same time as the sum of the many short duration dropouts. As a result the present invention provides an apparatus and method for detecting scratches which produce a large number of very short duration dropouts while at the same time identifying flaws which produce a single dropout but of substantial duration, which in the past has been very difficult to detect.

This is accomplished in brief by recording a color bar test pattern on a length of tape to be tested. Generally testing is done by recording the test pattern over the full length of tape. The tape is then played back in conventional manner to reproduce the modulated RF signal from the tape. A standard dropout detector circuit detects a loss of RF signal and generates an electrical impulse in which the duration of the impulse corresponds to the duration of the RF signal dropout. The impulses from the dropout detector are applied to a weighting and averaging circuit in the form of a pair of integrators and the output from the integrators is used to drive a suitable indicator, such as a strip chart recorder. Gross flaws are indicated by large amplitude swings of the recorder in response to the integrator output.

0014327

## Brief Description of the Drawings

For a more complete understanding of the invention, reference should be made to the accompanying drawings, wherein:

FIG. 1 is a block diagram of the tape evaluator system;

FIG. 2 shows a series of waveforms useful in explaining the operation of the weighting and averaging filter;

FIG. 3 is a schematic block diagram of a preferred embodiment of the weighting and averaging filter;

FIG. 4 shows the waveform at the output of the first integrator stage; and

FIG. 5 is a head scan correlator circuit used in the evaluator.

Detailed Description

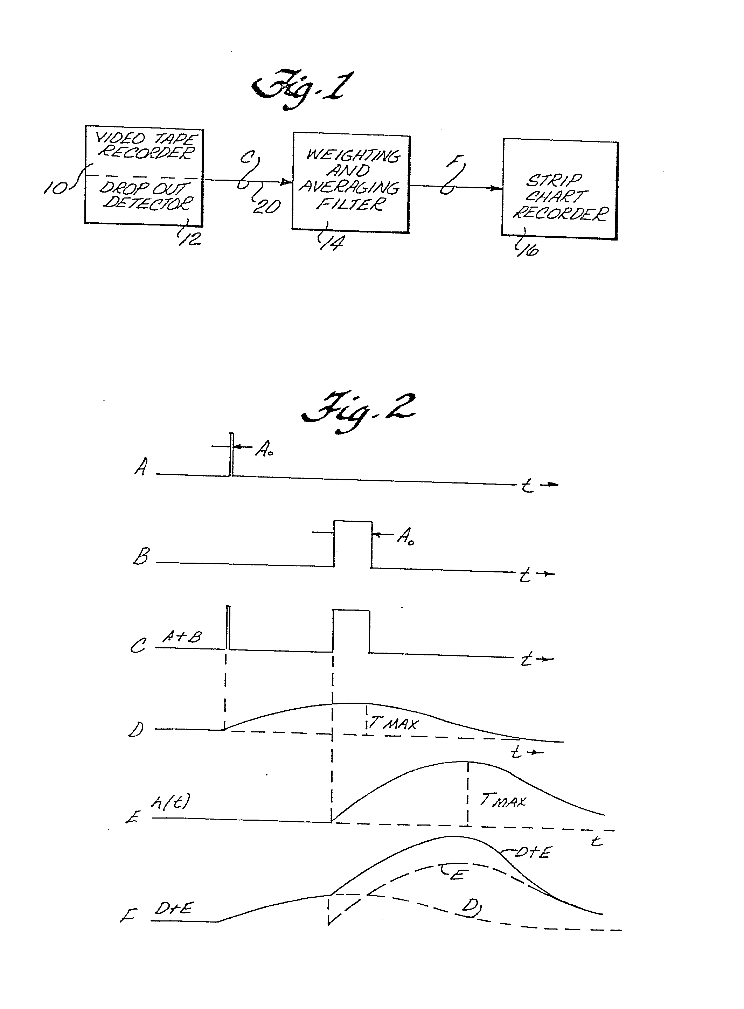

Referring to FIG. 1, the numeral 10 indicates generally a video tape recorder, which preferably is a quad head commercial type machine for magnetically recording and playing back full color video signals, such as for example, an AMPEX AVR-1 video tape recorder. However, it is to be understood that the invention is not limited to any particular type of recorder. Recorders that provide slant track scanning on narrower tape, such as video tape recorders sold for home use, may be used as well. The magnetic tape to be evaluated is loaded on the video tape recorder 10 and is then used to record a standard color bar test pattern video signal over the full length of the tape to be evaluated. The tape is then played back and the RF signal reproduced from the tape is applied to a dropout detector circuit 12 in the video tape recorder. The dropout detector 12 is a standard circuit in the AMPEX AVR-1 VTR, for example. The dropout detector detects the momentary loss of RF playback signal and provides output logic level gating pulses that are coincident with the dropout. Switching between levels occurs to form the leading edge of the gating pulse when the RF signal drops below the 16 DB of of the peak RF amplitude. The level is switched back again to form the trailing edge of the gating pulse when the RF signal is restored to within -10 DB of the peak RF amplitude. In FIG. 2 waveforms A, B, and C represent typical dropout pulses at the output of the dropout detector 12. FIGS. 2A and 2B represent dropout pulses of different duration, while FIG. 2C represents two successive dropouts of different time duration.

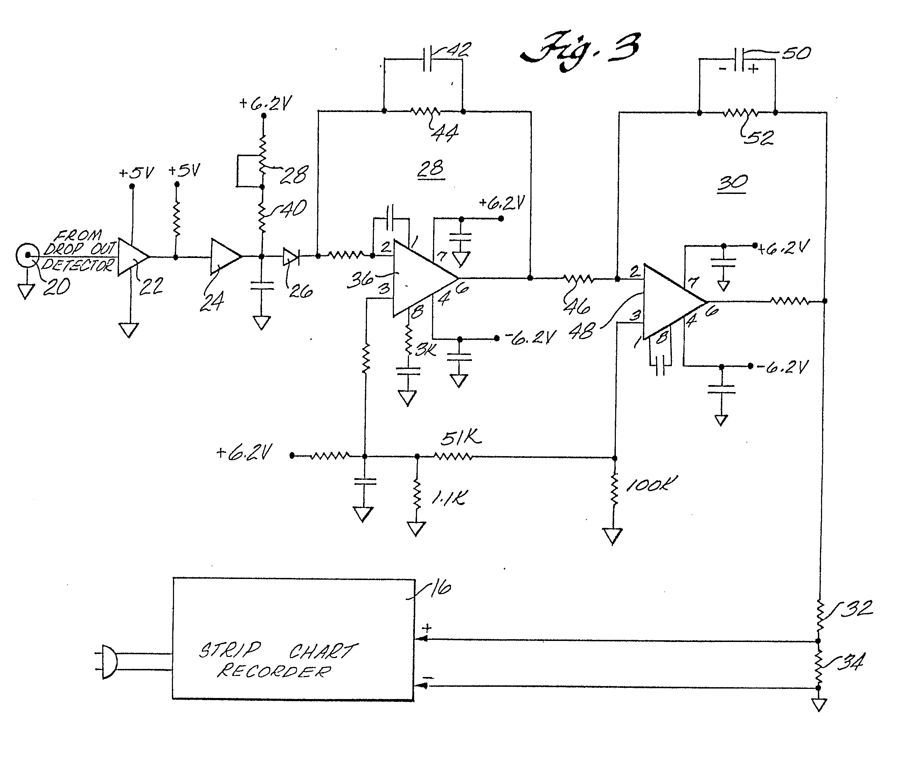

The dropout pulses from the dropout detector 12 are applied to the input of a weighting and averaging filter 14, hereinafter described in detail in connection with FIG. 3. The filter 14 is basically an analog double integrator circuit which integrates the area of the dropout pulses. The output signal from the weighting and averaging filter 14 for the dropout pulse shown in FIG. 2A, is shown in FIG. 2D. The waveforms of the output of the filter 14 for the dropout pulses shown in waveforms of FIGS 2B, and 2C are shown in FIGS. 2E and 2F. It should be noted that the time for reaching peak amplitude at the output of the filter 14 is substantially independent of pulse duration time $A_o$, but the peak amplitude $V_{max}$ is directly proportional to the time duration $A_o$. It should be further noted that if two dropout pulses occur close together, as shown by the waveform in FIG. 2C, the resulting output of the weighting and averaging filter 14 is the sum of the voltages produced by each of the dropout pulses individually, as shown by the waveform in FIG. 2F. The waveform of the output of the filter 14 in response to an input dropout pulse having a time duration of $A_o$ may be expressed as follows:

$$h(t) = A_o Kte^{-at} \qquad (1)$$

where K is a gain constant and $\underline{a}$ is a time constant of the filter.

The output of the weighting and averaging filter is preferably applied to a strip chart recorder or other instrument for displaying the output waveform from the weighting and averaging filter 14. By examining the strip chart recorder, it can be seen when the peaks at the output of the filter 14 exceed a predetermined amplitude value, indicating an area on tape in which the frequency and/or the duration of dropouts exceeds an acceptable level.

The value of the time constant $\underline{a}$ and the gain constant K for the transfer function of the weighting and averaging filter 14 can be determined by selecting the desired time for the output of the filter to reach a peak value $V_{max}$ and by selecting a value for $A_o$ which will produce full scale deflection of the strip chart recorder. The time required to reach the maximum value $V_{max}$ is selected

to be greater than the slew time for full deflection of the recorder and, by way of example only, was selected to be 2.25 seconds. The full scale output was selected to correspond to a single dropout of $A_o$=500 microsecond duration, which is approximately the time of one half of one head scan interval in a quad type VTR (or 8 television raster horizontal lines). From equation 1 it will seen that for the maximum value of $h(t)$, the first derivative $h'(t)$ is set equal to 0.

Thus $h'(t) = (1-at)\varepsilon^{-at} = 0$           (2)

By selecting t= 2.25 sec. in equation 2, it will be seen that the time constant $\underline{a} = \frac{1}{2.25}$ sec$^{-1}$. Assuming full scale on the strip chart recorder is 100 millivolts, for example, then the gain constant value K for the filter 14 can be determined from equation 1 by substituting .100 for the value of $h(t)$, and $500 \times 10^{-6}$ for the value $A_o$ and 2.25 seconds for the value of t. The result is K = 241.6. Substituting in these values for $\underline{a}$ and K in equation 1, the desired transfer function of the weighting and averaging filter 14 becomes

$$h(t) = A_o(241.6) \, te^{-t/2.25} \qquad (3)$$

It should be noted that the absolute values for $\underline{a}$ and K are given by way of example only.

The gain constant is selected primarily to fit the sensitivity of the output indications. The time constant $\underline{a}$ is made long enough to exceed the slew time of the recorder but short enough to distinguish between dropouts which are only a few seconds apart, a necessary requirement for identifying tape flaws apart from ordinary background dropout activity.

Referring to FIG. 3 there is shown a schematic circuit diagram of a weighting and averaging filter having the transfer characteristic of equation 1. The dropout pulses from the dropout detector are applied to the input terminal 20 of the circuit which is connected to a pair of open collector gates connected in series, as indicated at
22 and ;24. In the quiescent condition, the output from the
gate 24 normally back-biases a diode 26 and disabling a first
integrator stage, indicated generally at 28. The output
of the first integrator stage in turn is connected to the
input of a second integrator stage 30, the output of
which is applied to the strip chart recorder 16 through
a voltage divider formed by a pair of resistors 32 and 34.
The voltage divider merely limits the gain factor of the
weighting and averaging filter to match the sensitivity
of the strip chart recorder.

The first integrator stage 28 is in the form of an
operational amplifier type integrator circuit which includes
a high gain amplifier 36. The input resistance to the summing
junction at the input of the amplifier is provided by a pair
of series resistors 38 and 40. The resistor 38 is preferably
made adjustable to adjust the gain of the filter. The feedback
of the operational amplifier includes a capacitor 42 and shunt
resistor 44. Because of the shunt resistor 44, the first stage
is not a true integrator. The circuit comprising capacitor
42 and resistor 44 forms the time constant for the first
integrator.

The output of the first integrator stage is connected
through an input resistor 46 to the summing junction at the
input of an operational amplifier 48 in the second integrator
stage. Again the feedback path of the operational amplifier
includes an integrating capacitor 50 shunted by a resistor 52
whose time constant is the same as the first integrator stage.

It will be seen in FIG. 3 that when no dropout is
present at the input, the diode 26 is back-biased and the
output of the filter remains at substantially zero. When
a dropout pulse is encountered, the diode 26 is forward-
biased so that a constant reference voltage of 6.2 volts
is applied to the input resistors 38 and 40. As a result,
the capacitor 42 charges for the period of time $A_o$ that the

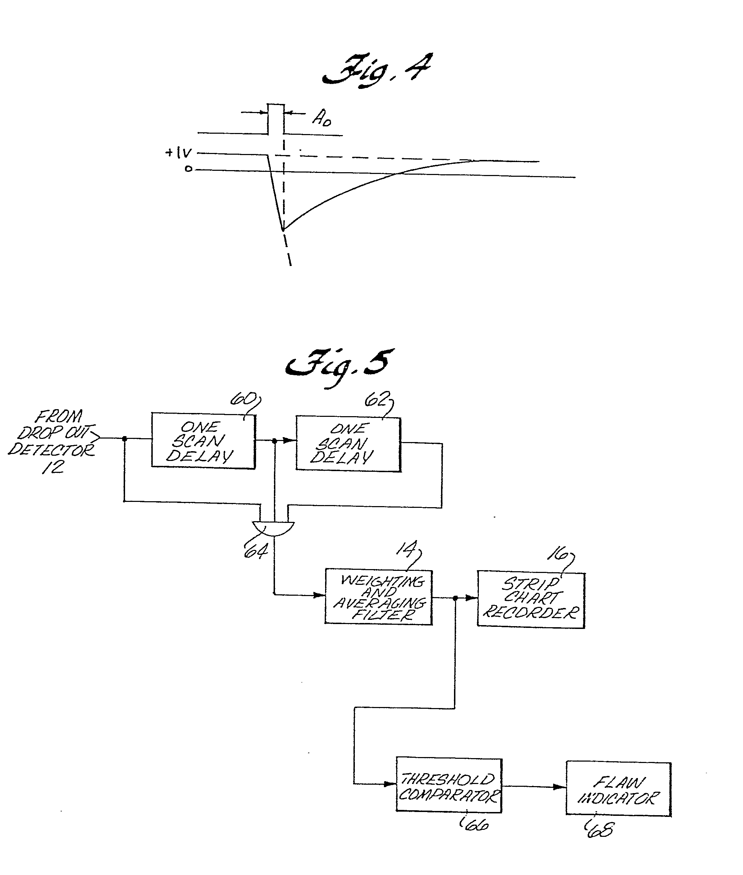

dropout pulse is on. When the dropout pulse is terminated, the capacitor 42 discharges gradually through the shunt resistor 44. The waveform of the output of the first integrator stage 28 is shown in FIG. 4. The +1 volt bias level is required to normally back-bias the diode 26. This DC bias voltage is cancelled out in the second integrator stage 30. It should be noted that normally the time $A_o$ is extremely short compared to the discharge time of the capacitor 42 through the resistor 44 so that the first integrator stage may be considered as generating an exponentially decaying signal having an initial amplitude proportional to the dropout pulse duration time $A_o$.

The second integrator stage 30 integrates the exponentially decaying signal from the first integrator stage by charging the capacitor 50 at a diminishing rate. When the charging rate from the output of the first integrator is slower than the discharging rate produced by the shunt resistor 52, the output voltage of the second stage 30 drops off toward zero. It should be noted that the parallel feedback networks of the two integrator circuits have approximately the same RC time constant. However, a much larger capacitor is provided in the second stage than in the first stage. Also the input resistor 46 of the second stage is very much larger than the series resistance of the resistors 38 and 40 at the input of the first stage. Thus the charging rate of the capacitor 50 in the second stage 30 is very much slower than the charging rate of the capacitor 42 in the first stage 28.

The circuit of FIG. 3 can be seen to match the desired transfer characteristic of Equation 3 from the following analysis. The exponentially decaying voltage at the output of the first stage, expressed in the s domain of the Leplace transform, can be expressed as S, based on the exponential discharge of the integrator,

$$V_1(s) = \frac{A_o K_1}{s + a} \tag{4}$$

where $\underline{a} = \dfrac{1}{R_{44}C_{42}} = \dfrac{1}{2.25}$

$K_1 = \dfrac{(6.2 \quad -1\ )}{C_{42}(R_{38} + R_{40})} = $ 3151.5 to 34667 nominally depending on setting of $R_{28}$

The gain introduced by the second stage may be expressed as

$$V_2(s) = \frac{K_2}{s + a} \tag{5}$$

where $a = \dfrac{1}{R_{52}C_{50}} = 2.25$

and $K_2 = \dfrac{1}{R_{46}\ C_{50}} \times \dfrac{R_{34}}{R_{34} + R_{32}} = .02$

The amplitude of the output of the second stage in combination with the first stage can then be expressed

$$h(s) = V_1(s) \times V_2(s) = \frac{A_o\ K}{(s + a)^2} \tag{6}$$

The inverse of the Laplace transform back to the time domain results in:

$$h(t) = A_0 K t e^{-at}$$

where $K = K_1 \times K_2 = 54$ to 693 (depending on the setting

of $R_{28}$ in the first stage).

Thus it will be seen that the circuit of FIG. 3 provides the desired transfer characteristic discussed above in connection with equations 1 and 3.

While the time constant a was selected to be 2.25 seconds for the two RC feedback circuits 42, 44, and 50, 52, this value could be selected to be as short as 10 milliseconds to as long as 10 seconds for a circuit to analyze tape on a quad head VTR. It should not be shorter than the response time of the strip chart recorder. The time constant a should be long enough to average over a number of scans by each of the heads. There is approximately one head scans per millisecond in the AVR-1 recorder, for example.

In evaluating the tape it is desirable to locate actual physical tape defects, such as embedded surface debris, holes, or scratches in the oxide, backing creases, and other oxide coating defects. Furthermore, small defects which only arise in one head scan do not generally represent potential problems. Larger surface defects, which are scanned by more than one head, are more apt to lead to head clogging and ultimate destruction of the tape. Correlation of dropouts at the head scan rate can be used to descriminate against random dropouts and other noise, leaving only dropouts that reoccur at the head scanning rate to be evaluated.

In the correlation circuit of FIG. 5, the signal from the dropout detector is applied to two delay circuits 60 and 62 connected in series. Each delay circuit introduces a delay corresponding to the period of one head scan. In the case of a standard quad head VTR, the head scanning rate is 960 scans per second, or a scan period of 1/960 seconds per scan. The delayed outputs are applied to an AND gate 64 together with the output from the dropout detector 12. Thus if a flaw is detected at the same position in three successive head scans, the output of the AND gate will go true, providing a dropout pulse to the input of the weighting and averaging filter 14. Additional delays in series may be used to extend the coincidence requirement over more than three tracks on the magnetic tape. Two delays are shown for illustration only.

-13-

One, two or more delays could be used to provide varying amounts of noise immunity.

While various types of delay circuits may be used, one suitable delay is a shift register. The dropout pulse can be quantized and stored as succession of bits of the same binary value in the register, the number of such bits corresponding to the duration of the dropout pulse. These bits are shifted serially through the shift register at a shift rate providing the desired 1/960 second delay. For example, a 1024 bit shift register shifted at a clock rate of 960 x 1024 would provide the desired one head scan delay.

While a strip chart has been shown as providing an indication of the amplitude peaks generated by dropout pulses applied to the weighting and averaging filter, the filter output could also be applied to a threshold comparator circuit 66 which provides a flaw indication whenever the output of the weighting and averaging filter exceeds a predetermined threshold level. While the preferred embodiment of the invention uses an analog circuit for the weighting and averaging filter, it will be appreciated by those skilled in the art that an equivalent filter can be implemented using digital rather than analog techniques.

ELECTRONIC VIDEO TAPE EVALUATOR

WHAT IS CLAIMED IS:

1. Apparatus for detecting flaws on color video magnetic recording tape on which a color bar test pattern has been magnetically recorded, comprising: playback means for reproducing an r-f output signal from the magnetic tape, dropout detector means responsive to the r-f signal for generating a pulse when the r-f output signal drops below a predetermined level during playback, the duration of the pulse corresponding to the time the output signal is below a predetermined level, an integrating circuit connected to the output of the dropout detector for integrating the pulses, and means indicating changes in the output of the integrating circuit.

2. Apparatus of claim 1 wherein said means indicating changes in the output of the integrating circuit includes a recording oscillograph having a predetermined rate of response that is slow compared to the time duration of said pulses from the dropout detector means.

3. Apparatus of claim 1 wherein the integrating circuit comprises an impulse weighting and averaging filter for generating an output signal that averages a plurality of input pulses over a time period that is long compared to the duration of the individual pulses.

4. Apparatus of claim 3 wherein the impulse weighting and averaging filter produces an output signal whose peak amplitude is directly related to the time duration of said pulses.

5. Apparatus of claim 1 wherein the integrating circuit includes first and second integrating stages in series.

6. Apparatus of claim 5 wherein the first integration stage includes an integrating capacitor, a series resistor for charging said capacitor in response to each of said electrical pulses to a voltage level proportional to the duration of each pulse, and a shunt resistor for discharging the capacitor at a rate that is substantially longer than the charging rate, and the second integration stage includes an integrating capacitor, a series resistor for charging the integrating capacitor, and a shunt resistor for discharging the capacitor.

7. Apparatus of claim 6 wherein the capacitor and series resistor of the second integrator have a substantially longer time constant than the capacitor and series resistor of the first integrator.

8. Apparatus of claim 7 wherein the capacitor and shunt resistor of the two integrators have substantially the same time constant.

9. A circuit for weighting and averaging a plurality of electrical pulses occurring at random time intervals and of varying pulse duration, comprising:

a first integration stage coupled to a source of said electrical pulses including an integrating capacitor, a series resistor for charging said capacitor in response to each of said electrical pulses to a voltage level proportional to the duration of each pulse, and a shunt resistor for discharging the capacitor at a rate that is substantially longer than the charging rate; and

a second integration stage coupled to the output of the first integrator stage including an integrating capacitor, a series resistor for charging the integrating capacitor, and a shunt resistor for discharging the capacitor.

10. Apparatus of claim 9 wherein the capacitor and series resistor of the second integrator have a substantially longer time constant than the capacitor and series resistor of the first integrator.

11. Apparatus of claim 10 wherein the capacitor and shunt resistor of the two integrators have substantially the same time constant.

12. Apparatus for locating flaws in magnetic tape on which a color bar test pattern signal has been recorded, comprising means including at least one magnetic head which scans the tape periodically at a fixed rate for reading back the test pattern signal recording on the tape, means generating a pulse when the signal played back drops below a predetermined level, the duration of the pulse being determined by the time the signal remains below a predetermined level; at least one delay circuit coupled to the output of the means generating a pulse for delaying the pulse by a time interval corresponding to a scan period of the magnetic head, a logical AND gate connected to the output of the means generating a pulse and the delay circuit, and integration means coupled to the output of the logical AND gate for integrating the output of the logical AND gate.

13. Apparatus of claim 14 further including a second delay circuit having the same delay time as the first delay circuit, the output of the second delay circuit being connected to an input to the logical AND gate.

14. A method of profiling magnetic tape to determine the quality of the tape, comprising the steps of:
recording an r-f signal over a portion of the tape length, playing back the r-f signal from the tape, generating a binary signal that switches to a first level when the r-f signal played back from the tape drops below a first level of signal strength and switches to a second level when the r-f signal exceeds a second level of signal strength, and weighting and averaging said binary signals over a time interval that is long compared to the duration of the binary signal at said first level.

Fig.1

VIDEO TAPE RECORDER
DROP OUT DETECTOR
10 / 12

C / 20

WEIGHTING AND AVERAGING FILTER
14

F

STRIP CHART RECORDER
16

Fig.2

A — $A_0$ — $t \rightarrow$

B — $A_0$ — $t \rightarrow$

C — A+B — $t \rightarrow$

D — $T\,MAX$ — $t \rightarrow$

E — $h(t)$ — $T\,MAX$ — $t$

F — D+E — D+E, E, D

*Fig. 3*

3/3

*Fig. 4*

*Fig. 5*